# EUROPEAN PATENT APPLICATION

(11) **EP 4 489 080 A1**
(43) Date of publication of application: **08.01.2025**
(21) Application number: 22940747.3
(22) Date of filing: 18.10.2022
(51) Int. Cl.: H01L 29/78, H01L 29/06, H01L 29/423, H01L 21/336

(54) **SILICON CARBIDE MOSFET DEVICE AND MANUFACTURING METHOD THEREFOR**

(30) Priority: 06.05.2022 CN 202210484974; 06.05.2022 CN 202221074903 U
(71) Applicant: Hubei Jiufengshan Laboratory, Wuhan, Hubei 430070 (CN)
(72) Inventor: YUAN, Jun, Wuhan, Hubei 430070 (CN)
(74) Representative: KASTEL Patentanwälte PartG mbB
(86) International application number: PCT/CN2022/125789
(87) International publication number: WO 2023/213053

(57) **Abstract**

Disclosed in the present application are a silicon carbide MOSFET device and a manufacturing method therefor. The silicon carbide MOSFET is provided with a first withstand voltage masking structure and a second withstand voltage masking structure. The withstand voltage performance of the device is improved, the breakdown problem of a gate insulating dielectric layer can be avoided, the electrostatic effect of the device on a severe environment and the high-voltage peak tolerance capability in the circuit are improved, and the surge voltage resistance of the device and the over-voltage protection capability are improved. Ion implantation can be carried out on a first trench to form the first withstand voltage masking structure, and ion implantation can be carried out on a second trench to form the second withstand voltage masking structure. A large-depth ion implantation area in a silicon carbide epitaxial layer can be achieved without high-dose and high-energy ion implantation, so that the manufacturing process is simple, and the manufacturing cost is low.

## Description

The present application claims priority to Chinese patent Application No. 202210484974.6, titled "SILICON CARBIDE MOSFET DEVICE AND METHOD FOR MENUFACTURING THE SAME", filed on May 06, 2022, with the China National Intellectual Property Administration, which is incorporated herein by reference in its entirety. The present application claims priority to Chinese patent Application No. 202221074903.0, titled "SILICON CARBIDE MOSFET DEVICE", filed on May 06, 2022, with the China National Intellectual Property Administration, which is incorporated herein by reference in its entirety.

### FIELD

The present disclosure relates to the technical field of semiconductor devices, in particular to a silicon carbide MOSFET device and a method for manufacturing the silicon carbide MOSFET device.

### BACKGROUND

Silicon carbide (SiC) is quite appealing in high-power electronics due to its excellent properties and has become an ideal material for power metal-oxide-semiconductor field-effect-transistors (MOSFETs) with high performances. In general, SiC-based vertical power MOSFET devices include lateral double-diffusion MOSFET (DMOSFET) and vertical trench-gate MOSFET (UMOSFET).

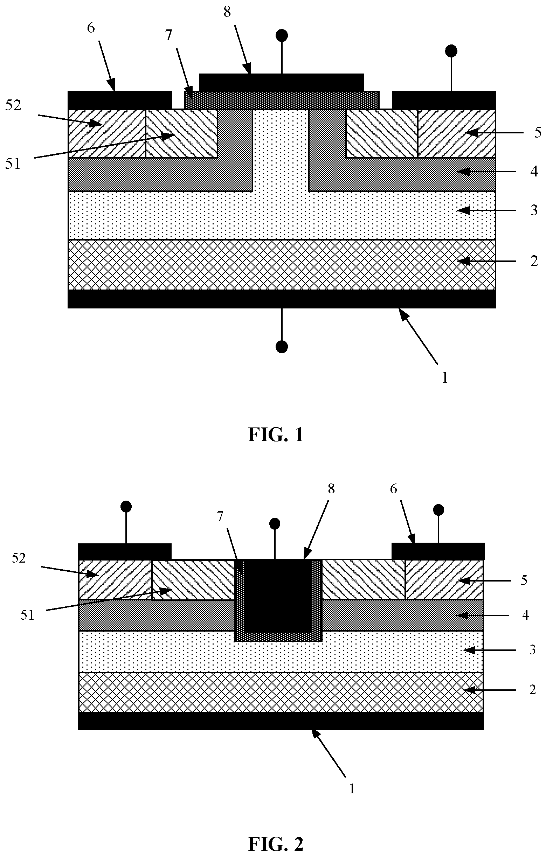

Reference is made to FIG. 1, which is a schematic structural diagram of a DMOSFET. The DMOSFET comprises an n+ (heavily n-doped) substrate 2, an n- (lightly n-doped) drift region 3 disposed on a surface of the substrate 2, a p-type well region 4 disposed in the drift region 3, and a source region 5 disposed in the p-type well region. The source region 5 comprises an n+ doped region 51 and a p+ (heavily p-doped) doped region 52. A gate dielectric layer 7 is disposed on a surface of the drift region 3, and a gate electrode 8 is disposed on a surface of the gate dielectric layer 7. A drain electrode 1 is located on a surface of the substrate 2 facing away from the drift region 3.

The DMOSFET structure adopts planar diffusion. A gate made of a refractory material such as polysilicon serves as a mask, and a p-type base region and an n+ source region are defined by an edge of the gate. The name "DMOS" origins from double diffusion, in which a surface channel region is formed by using a difference between lateral diffusion in the p-type base region and lateral diffusion in the n+ source region.

Reference is made to FIG. 2, which is a schematic structural diagram of a UMOSFET. A difference from the structure as shown in FIG. 1 is that a U-shaped trench is provided in the UMOSFET. A surface of the U-shaped trench is covered with a gate dielectric layer 7, and the U-shaped trench is filled with a gate electrode 8. The name "UMOSFET", which is vertical and has a trench gate, origins from the U-shaped trench. The U-shaped trench is formed in a gate region through reactive ion etching. The U-shaped trench allows a high channel density (where the channel density is defined by a width of a channel in an active region), such that the characteristic ON-state resistance of the device is significantly reduced.

Some manufacturers have already launched commercial products of planar SiC MOSFETs after years of research in the field. Modern Techniques for conventional lateral DMOSFETs has reached a point at the On-resistance of a MOS cell cannot be reduced with miniaturization of the MOS, mainly due to limitation of resistance in a JFET neck region. That is, it is hard to decrease the ON-resistance per unit area to 2mΩ·cm² even when decreasing a dimension of photolithography. Such issues can be effectively addressed by using the U-shaped trench structure as shown in FIG. 2. The U-shaped trench structure utilizes trench etching techniques for manufacturing storage capacitors in memories, which turns a channel from horizontal to vertical. Compared with the conventional structures, the JFET neck resistance is eliminated, and a density of cells is greatly increased, which improves a capability of the power semiconductor in handling currents.

In conventional technology, the SiC-based UMOSFETs still have several problems in actual manufacturing and application.

First, a high electrical field in a drift region made of SiC results in a high electrical field on the gate dielectric layer. The problem is exacerbated at corners of the trench, and hence the gate dielectric layer is subject to rapid breakdown under a high drain voltage. Thereby, the UMOFETs have poor tolerance against harsh electrostatic environments and large voltage spikes in a circuit.

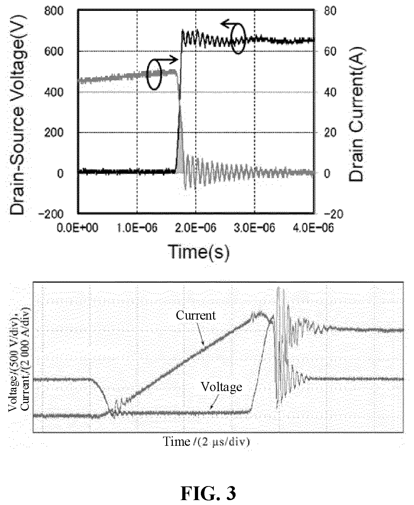

Second, SiC-based power MOSFETs are mainly applied to high-voltage, high-frequency, and large-current electronics, and hence parasitic parameters in a circuit may generate spikes and glitches during high-frequency switching. Reference is made to Figure 3, which shows a waveform diagram of overshoot and oscillation in a voltage when a MOSFET is switched between on and off. It can be seen from Figure 3 that an instantaneous overvoltage increases a loss due to the switching, and a large surge voltage is generated due to a change in a power load. Hence, anti-surge and overvoltage protection of the MOSFETs are very important.

Conventional MOSFET devices do not have a function of anti-surge and overvoltage protection. Hence, in practice, it is often necessary to provide a buffer circuit, a surge suppressing circuit, and an overvoltage protection circuit, which are complex. Such external matching circuits for suppression and overvoltage protection are often subject to a time delay. Accordingly, the high-frequency spike voltage surge is still directly borne by the device in practical switching, which sometimes results in breakdown of the channel region and gradual failure of the gate structure and ohmic-contact region of electrodes. That is, there would be reliability issues.

Third, a limited depth of ion implantation techniques makes it difficult to implement pertinent protective and anti-surge structures for the trench gate. Generally, a depth of the trench for forming the gate electrode is greater than 1µm or even 2µm. In practice, a buried protective structure, which is capable to protect the gate in the trench, cannot be fabricated directly through ion implantation, because a depth of ion implantation can hardly exceed 1 µm in silicon carbide. In conventional technology, a required doped region is first formed in a precedent epitaxial layer through etching and ion implantation, and then two p-type epitaxial layers having a specific structure are formed. Such manufacturing process is a complicated and costly.

### SUMMARY

In view of the above, a silicon carbide (SiC) metal-oxide-semiconductor field-effect-transistor (MOSFET) device and a method for manufacturing the SiC MOSFET transistor device are provided according to embodiments of the present disclosure.

A SiC MOSFET device is provided according to an embodiment of the present disclosure. The SiC MOSFET comprises: a SiC epitaxial layer, comprising a first surface and a second surface that are opposite to each other, where a buried layer is disposed between the first surface and the second surface, the first surface comprises a gate region and a source region, and the source region is located at two sides of the gate region; a first trench opening in the gate region and a trench gate disposed in the first trench, where the first trench is located at a side of the buried layer away from the second surface, and the first trench is spaced apart from the buried layer; a second trench opening in the source region and a trench source disposed in the second trench; a first voltage-resistant shielding structure embedded in the silicon carbide epitaxial layer at a bottom of the first trench, where the first voltage-resistant shielding structure is spaced apart from the buried layer; and a second voltage-resistant shielding structure embedded in the SiC epitaxial layer at a surface of the second trench, where the second voltage-resistant shielding structure is in contact with the buried layer.

In a preferable embodiment, the buried layer comprises a first ion-implanted region formed through the first trench, where the first ion-implanted region runs through the buried layer and is spaced apart from the first voltage-resistant shielding structure.

In a preferable embodiment, the first trench is a single-level trench, a width of the first ion-implanted region is less than a width of the single-level trench, and a width of the first voltage-resistant shielding structure is less than the width of the single-level trench.

In a preferable embodiment, a depth of the first trench is less than a depth of the second trench. A well region is located between the first trench and the second voltage-resistant shielding structure, and a depth of the well region is less than the depth of the first trench. A part of the SiC epitaxial layer located at a side of the well region away from the second surface serves as a second ion-implanted region, and a polarity of dopants in the well region is opposite to a polarity of dopants in the second ion-implanted region.

In a preferable embodiment, the second trench is a multi-level stair trench. The second voltage-resistant shielding structure is a third ion-implanted region formed through the multi-level stair trench, and the third ion-implanted region is embedded in the SiC epitaxial layer at a bottom of the multi-level stair trench, a sidewall of each level of the multi-level stair trench, and a step surface between every two adjacent levels of the multi-level stair trench.

In a preferable embodiment, a bottom of the second trench is located at a side of the buried layer away from the second surface and is spaced apart from the buried layer. At least a portion of the second voltage-resistant shielding structure runs into the buried layer.

In a preferable embodiment, at least a portion of the second trench runs into the buried layer.

In a preferable embodiment, the trench gate comprises polysilicon filling the first trench, and a gate metal is disposed on a surface of the polysilicon filling the first trench. The trench source comprises polysilicon filling the second trench, and a source metal is disposed on a surface of the polysilicon filling the second trench. An insulating dielectric layer comprises a part disposed between the first trench and the polysilicon filling the first trench, a part disposed between the second trench and the polysilicon filling the second trench, and a part covering the first surface. The part covering the first surface comprises an opening that exposes a portion of the first surface, the opening is configured to accommodate an ohmic contact layer, and the source metal covers the ohmic contact layer.

In a preferable embodiment, a SiC substrate is disposed on the second surface, and a drain metal is disposed at a side of the SiC substrate away from the SiC epitaxial layer.

A method for manufacturing the SiC MOSFET device in any foregoing embodiment is further provided according to an embodiment of the present disclosure. The method comprises: providing an epitaxial wafer comprising a SiC epitaxial layer, where the SiC epitaxial layer comprises a first surface and a second surface that are opposite to each other, a buried layer is disposed between the first surface and the second surface, the first surface comprises a gate region and a source region, and the source region is located at two sides of the gate region; forming a first trench opening in the gate region and forming a second trench opening in the source region, where the first trench is located at a side of the buried layer away from the second surface, and the first trench is spaced apart from the buried layer; forming a first voltage-resistant shielding structure in the SiC epitaxial layer through the first trench and forming a second voltage-resistant shielding structure in the SiC epitaxial layer through the second trench, where the first voltage-resistant shielding structure is spaced apart from the buried layer, and the second voltage-resistant shielding structure is in contact with the buried layer; and forming a trench gate in the first trench and forming a trench source in the second trench.

In a preferable embodiment, before forming the first voltage-resistant shielding structure and forming the second voltage-resistant shielding structure, the method further includes: implanting ions into the buried layer through the first trench to form a first ion-implanted region in a region of the buried layer corresponding to the first trench, where the first ion-implanted region runs through the buried layer and is spaced apart from the first voltage-resistant shielding structure.

In a preferable embodiment, forming the first trench in the gate region and forming the second trench in the source region comprises: forming a trench of a first level in the source region through first etching; forming a single-level trench in the gate region and forming a trench of a second level overlapping with the trench of the first level, through second etching, where an etching window of the second etching is larger than an etching window of the first etching, the trench of the first level is deepened while forming the trench of the second level, the first trench comprises a single-level trench, and the second trench is a two-level stair trench comprising the deepened trench of the first level and the trench of the second level.

In a preferable embodiment, the method further comprises: forming a well region and a second ion-implanted region that are embedded in the first surface, where a polarity of dopants in the second ion-implanted region is opposite to the polarity of dopants in the well region, the well region is located between the first trench and the second voltage-resistant shielding structure, and a depth of the well region is less than a depth of the first trench.

In a preferable embodiment, an electric-field buffering region in the first surface surrounds the second trench. Forming the first voltage-resistant shielding structure in the SiC epitaxial layer through the first trench and forming the second voltage-resistant shielding structure in the SiC epitaxial layer through the second trench comprises: forming a mask layer covering the first surface and a sidewall of the first trench; and through ion implantation under masking of the mask layer, forming the first voltage-resistant shielding structure in the SiC epitaxial layer at a bottom of the first trench, and forming the second voltage-resistant shielding structure at a sidewall and a bottom of the second trench, where the electric-field buffering region surrounds the second voltage-resistant shielding structure.

In a preferable embodiment, forming the trench gate in the first trench and forming the trench source in the second trench comprises: forming an insulating dielectric layer that covers the first surface, a surface of the first trench, and a surface of the second trench; filling the first trench and the second trench with polysilicon, where the trench gate comprises the polysilicon filling the first trench, a gate metal is disposed on a surface of the polysilicon filling the first trench, the trench source comprises the polysilicon filling the second trench, and a source metal is disposed on a surface of the polysilicon filling the second trench.

Thereby, the SiC MOSFET device and the method for manufacturing the SiC MOSFET device are provided according to technical solutions of the present disclosure. The SiC MOSFET comprises the first voltage-resistant shielding structure and the second voltage-resistant shielding structure. Voltage endurance of the SiC MOSFET device is improved, breakdown of the gate insulating dielectric layer is avoided, the SiC MOSFET device is more robust against an electrostatic effect under a harsh environment and high-voltage spikes in circuits, and an anti-surge capability and an anti-overvoltage capability of the SiC MOSFET device are improved. Moreover, the first voltage-resistant shielding structure may be formed through implanting ions via the first trench, and the second voltage-resistant shielding structure may be formed through implanting ions via the second trench. Thereby, deep ion-implanted region can be achieved in the SiC epitaxial layer without implanting ions under a high dose and high energy. The manufacturing is thus simple in processing and low in costs.

### BRIEF DESCRIPTION OF THE DRAWINGS

In order to clarity illustration of the technical solutions according to embodiments of the present disclosure or conventional technology, hereinafter the drawings to be applied in embodiments of the present disclosure or technology are briefly described. Apparently, the drawings in the following descriptions are only some embodiments of the present disclosure, and other drawings may be obtained by those skilled in the art based on the provided drawings without creative efforts.

Structures, proportions, dimensions, and the like as shown in the drawings of this specification are intended for facilitating understanding and intelligibility for those skilled din the art in conjunction with content disclosed herein, not for limiting a condition of implementing the present disclosure, and hence do not represent practical techniques. Any structural modifications, changes in proportions, or adjustments in dimensions shall fall within the scope of the present disclosure as long as not affecting an effect or an objective of embodiments the present disclosure.
FIG. 1 is a schematic structural diagram of a double-diffusion MOSFET (DMOSFET).
FIG. 2 is a schematic structural diagram of a trench-gate MOSFET (UMOSFET).
FIG. 3 is a waveform diagram of overshoot and oscillation in a voltage when switching a MOSFET between on and off.
FIG. 4 is a schematic structural diagram of a silicon carbide MOSFET device according to an embodiment of the present disclosure.
FIG. 5 is a schematic structural diagram of a silicon carbide MOSFET device according to another embodiment of the present disclosure.
FIGs. 6 to 27 are schematic structural diagrams in a process of manufacturing a silicon carbide MOSFET device according to embodiments of the present disclosure.

### DETAILED DESCRIPTION OF EMBODIMENTS

Hereinafter technical solutions in embodiments of the present disclosure are described clearly and completely in conjunction with the drawings in embodiments of the present closure. Apparently, the described embodiments are only some rather than all of the embodiments of the present disclosure. Any other embodiments obtained based on the embodiments of the present disclosure by those skilled in the art without any creative effort fall within the scope of protection of the present disclosure.

Hereinafter the present disclosure is further illustrated in detail in conjunction with the drawings and specific embodiments, in order to elucidate and clarify objectives, features, and advantages of the present disclosure.

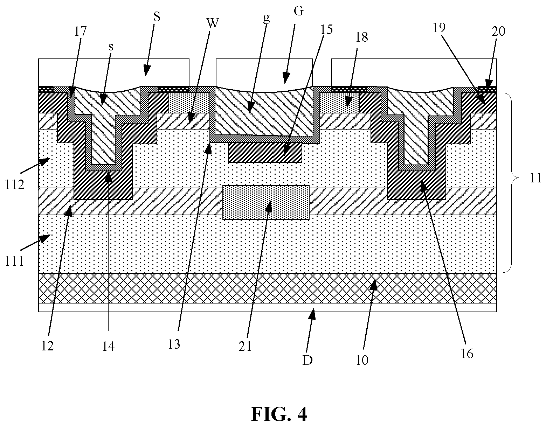

Reference is made to FIG. 4, which is a schematic structural diagram of a silicon carbide (SiC) metal-oxide-semiconductor field-effect-transistor (MOSFET) device according to an embodiment of the present disclosure. The SiC MOSFET device comprises a SiC epitaxial layer 11, a first trench 13, a trench gate g, a second trench 14, a first voltage-resistant shielding structure 15, and a second voltage-resistant shielding structure 16.

The SiC epitaxial layer 11 comprises a first surface and a second surface that are opposite to each other. A buried layer 12 is disposed between the first surface and the second surface. The first surface comprises a gate region and a source region, and the source region is located at two sides of the gate region.

The first trench 13 opens in the gate region, and the trench gate g is located in the first trench 13. The first trench 13 is located at a side of the buried layer 12 away from the second surface, and the first trench 13 is spaced apart from the buried layer 12.

The second trench 14 opens in the source region, and the trench source s is located in the second trench 14.

The first voltage-resistant shielding structure 15 is embedded in the SiC epitaxial layer 11 at a bottom of the first trench 13, and the first voltage-resistant shielding structure 15 is spaced apart from the buried layer 12.

The second voltage-resistant shielding structure 16 is embedded in the SiC epitaxial layer 11 at a surface of the second trench 14, and the second voltage-resistant shielding structure 16 is in contact with the buried layer 12.

An insulating dielectric layer 17 is disposed between the trench gate g and a surface of the first trench 13. The first voltage-resistant shielding structure 15 is embedded in a bottom surface of the first trench 13, and there is no gap between the bottom surface of the first trench 13 and the first voltage-resistant shielding structure 15. Thereby, the insulating dielectric layer 17 on the surface of the first trench 13 can be better protected.

The SiC MOSFET comprises the first voltage-resistant shielding structure 15 and the second voltage-resistant shielding structure 16. Voltage endurance of the SiC MOSFET device is improved, breakdown of the gate insulating dielectric layer 17 is avoided, the SiC MOSFET device is more robust against an electrostatic effect under a harsh environment and high-voltage spikes in circuits, and an anti-surge capability and an anti-overvoltage capability of the SiC MOSFET device are improved. Moreover, the first voltage-resistant shielding structure 15 may be formed through implanting ions via the first trench 13, and the second voltage-resistant shielding structure 16 may be formed through implanting ions via the second trench 14. Thereby, deep ion-implanted region can be achieved in the SiC epitaxial layer without implanting ions under a high dose and high energy. The manufacturing is thus simple in processing and low in costs.

The SiC epitaxial layer 11 may comprises a first epitaxial layer 111 and a second epitaxial layer 112 which are arranged opposite to each other, and the buried layer 12 is located between the first epitaxial layer 111 and the second epitaxial layer 112. A surface of the first epitaxial layer 111 away from the second epitaxial layer 112 may serve as the second surface, and a surface of the second epitaxial layer 112 away from the first epitaxial layer 111 may serve as the first surface.

The SiC MOSFET device may comprise a SiC substrate 10 disposed on the second surface. A drain metal D may be arranged at a side of the SiC substrate 10 away from the SiC epitaxial layer 11.

The first ion-implanted region 21 formed through the first trench 13 may be located in the buried layer 12. The first ion-implanted region 21 runs through the buried layer 12, and the first ion-implanted region 21 is spaced apart from the first voltage-resistant shielding structure 15.

In the SiC MOSFET device, the first ion-implanted region 21 may be formed in the buried layer 12 and spaced apart from the first voltage-resistant shielding structure 15 beneath the trench gate g. The first ion-implanted region 21 runs through buried layer 12 to form a main current path for the device. Thus, a junction field-effect-transistor (JFET) structure is introduced into the current path to the drain. Conduction characteristics of the JFET structure may be optimized through adjusting a pattern, a dose of ion implantation, and a pattern, of the first ion-implanted region 21. Hence, designing and processing are flexible, which improves manufacturability.

In the SiC MOSFET device, a depth of the first trench 13 may be less than that of the second trench 14. Thereby, the second voltage-resistant shielding structure 16 has ions that are deeply implanted, and thus the second voltage-resistant shielding structure 16 is capable to connect the buried layer 12 to provide protection against a reverse voltage on a bottom and a trench-corner of the trench gate, which leads to a trench MOSFET device with high reliability. A well region W may be disposed between the first trench 13 and the second voltage-resistant shielding structure 16, and a depth of the well region W is less than that of the first trench 13. A part of the SiC epitaxial layer 11, which is located at a side of the well region W away from the second surface, may serve as a second ion-implanted region 18. The second ion-implanted region 18 and the well region W are opposite to each other in polarity of dopants. The well region W may be located at two sides of the first trench 13 and contact sidewall(s) of the first trench 13.

In an embodiment, the SiC substrate 10 may be a n+ SiC substrate, and the SiC epitaxial layer 11 may be an n- epitaxial layer, that is, both the first epitaxial layer 111 and the second epitaxial layer 112 are n- epitaxial layers. Each of the first voltage-resistant shielding structure 15 and the second voltage-resistant shielding structure 16 may be a p+ ion-implanted region. The well region W may be a p-doped ion-implanted region. The second ion-implanted region 18 may be a n+ ion-implanted region. The present disclosure is not limited to the above-listed doping type of each region. The doping types may be configured on requirement in order to form a structure of a p-channel MOSFET (PMOS) or an n-channel MOSFET (NMOS).

The first trench 13 may be a single-level trench. A width of the first ion-implanted region 21 is less than that of the single-level trench, and a width of the first voltage-resistant shielding structure 15 is less than that of the single-level trench. The first voltage-resistant shielding structure 15 needs to be arranged between the trench gate and the buried layer 12, and the first voltage-resistant shielding structure 15 and the buried layer 12 are spaced apart from each other, such that the JFET structure is formed in the SiC MOSFET device. Hence, a depth of ion implantation for forming the first voltage-resistant shielding structure 15 is not necessary to be large, and such depth can be achieved by using the single-level trench of a small depth as the first voltage-resistant shielding structure 15. Thus, the manufacturing is simple in processing and low in costs.

The second trench 14 may be a multi-level stair trench, and the second voltage-resistant shielding structure 16 may be a third ion-implanted region formed through the multi-level stair trench. The third ion-implanted region is embedded in the SiC epitaxial layer at a bottom of the multi-level stair trench, a sidewall of each level of the multi-level stair trench, and a step surface between every two adjacent levels of the multi-level stair trench. The second voltage-resistant shielding structure 16 is required to have a large depth to achieve connection between the second voltage-resistant shielding structure 16 and the buried layer 12. A large depth of the second voltage-resistant shielding structure 16 in the SiC epitaxial layer 11 can be achieved by using the multi-level stair trench as the second trench 14 without implanting ions under a high dose and high energy.

In an optional embodiment, the multi-level stair trench is a two-level stair trench. Generally, the buried layer 12 is located at a depth of approximately 2µm in a SiC epitaxial wafer comprising the SiC substrate 10 and the SiC epitaxial layer 11, and a depth of the first trench 13 for preparing the trench gate is approximately 1µm. Using the two-level stair trench as the second trench 14 is capable to meet a requirement on the depth of ion implantation for forming the second voltage-resistant shielding structure 16 without implanting ions under a high dose and high energy or damaging a lattice structure of the SiC severely.

In an embodiment as shown in FIG. 4, the bottom of the second trench 14 is located at a side of the buried layer 12 away from the second surface and is spaced apart from the buried layer 12. At least a portion of the second voltage-resistant shielding structure 16 runs into the buried layer 12, so that the second voltage-resistant shielding structure 16 is connected to the buried layer to protect the trench gate better. In such case, the bottom of the second voltage-resistant shielding structure 16 may be located in the buried layer 12, as shown in FIG. 4. Alternatively, the bottom of the second voltage-resistant shielding structure 16 may be located below the buried layer 12.

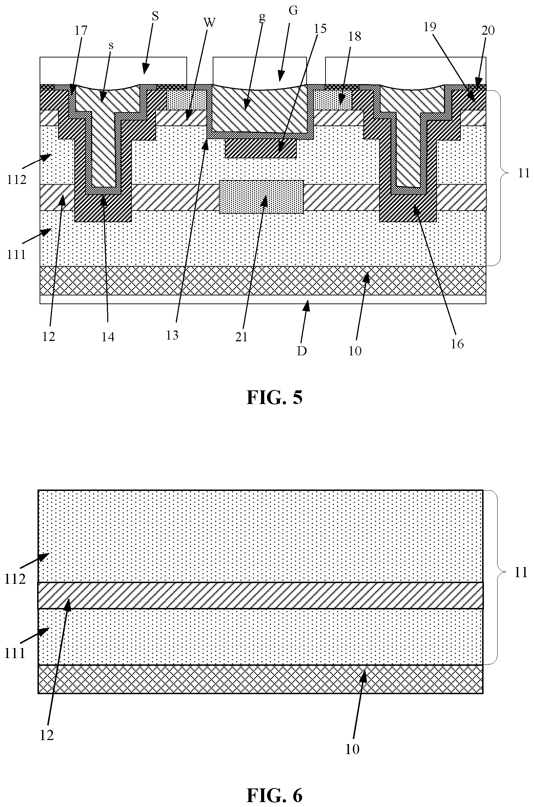

Reference is made to FIG. 5, which is a schematic structural diagram of a SiC MOSFET device according to another embodiment of the present disclosure. The structure as shown in FIG. 5 is that as shown in FIG. 4 in that at least a portion of the second trench 14 runs into the buried layer 12. In such case, the bottom of the second voltage-resistant shielding structure 16 may be located below the buried layer 12, as shown in FIG. 5.

The second voltage-resistant shielding structure 16 is formed through implanting ions via the second trench 14. The bottom of the second voltage-resistant shielding structure 16 may be located in the buried layer 12, as shown in FIG. 4, or below the buried layer 12, as shown in FIG. 5. A depth of the bottom of the second trench 14 with respect to the buried layer 12 may be configured on requirement. The bottom of the second trench 14 may be located above the buried layer 12, as shown in FIG. 4, or in the buried layer 12, as shown in FIG. 5. In another embodiment, the bottom of the second trench 14 may be located below the buried layer 12.

Herein in the SiC MOSFET device, the trench gate g may comprise polysilicon filling the first trench 13, and a gate metal G is disposed on a surface of such polysilicon. The trench source s may comprise polysilicon filling the second trench 14, and a source metal S is disposed on the surface of such polysilicon. An insulating dielectric layer 17 may comprise a part disposed between the first trench 13 and the polysilicon filled therein, a part disposed between the second trench 14 and the polysilicon filled therein, and a part covering the first surface. The part of the insulating dielectric layer 17 covering the first surface comprises an opening exposing a portion of the first surface, the opening is configured to accommodate an ohmic contact layer 20. The source metal S covers the ohmic contact layer 20.

The first surface may have an electric-field buffering region 19 surrounding the second trench 14. The electric-field buffering region 19 and the second voltage-resistant shielding structure 16 may be identical in polarity and concentration of dopants, for example, both may be p+ region. The electric-field buffering region 19 is configured to address leakage and breakdown due to a small thickness of the second voltage-resistant shielding structure 16 at a mouth of the second trench 14. Hence, manufacturability and reliability of the device can be improved.

Herein the SiC MOSFET device adopts processing in which the trench source s is integrated in at two sides of the trench gate g. The second trench 14 may be the two-level stair trench which leads to a two-level trench source. The second voltage-resistant shielding structure 16 is formed through ion implantation in the SiC epitaxial layer 11 at the bottom, the side wall of each level, and the step surface between the two levels, of the two-level stair trench. The bottom of the second voltage-resistant shielding structure 16 is located in the buried layer 12, or the second voltage-resistant shielding structure 16 runs through the buried layer 12 (that is, the bottom of the second voltage-resistant shielding structure 16 is located below the buried layer 12), so that the second voltage-resistant shielding structure 16 is in contact with the buried layer 12. Thereby, the second voltage-resistant shielding structure 16 is grounded (e.g., connected to the source), which introducing the JFET structure into the current path to the drain of the device. The second voltage-resistant shielding structure 16 forming the JFET structure is well connected to the source rather than floating, which shields the bottom of the trench gate better against the electric field and improves a self-suppression capability against surging current.

Moreover, the first voltage-resistant shielding structure 15 may be formed through the first trench 13, and the second voltage-resistant shielding structure 16 may be formed through the second trench 14, which addresses difficulties of forming a deep p+ shielding structure in SiC materials and damages and unreliability due to implanting p-type ions under a high dose and high energy. The trench gate g can be better shielded and protected. In a case that the second voltage-resistant shielding structure 16 is formed through implanting ions under high energy and a high dose into a depth larger than the range from 1µm to 2µm, severe damages are likely to be induced in the SiC material due to the ion implantation, which causes unreliability in long-term operation of the device. Herein the second voltage-resistant shielding structure 16 formed through the second trench 14 provides a convenient solution for forming a p+ electric field shielding structure at a depth of greater than the range from 1µm to 2µm. The formed second voltage-resistant shielding structure 16 can well shield and protect a sidewall and a bottom of the trench gate g and improve reliability of the gate in the SiC trench MOSFET device.

In the SiC MOSFET device, the first ion-implanted region 21 may be formed in the buried layer 12 of the epitaxial wafer to introduce the JFET structure in the current path to the drain of the device, and the JFET structure is grounded via the two-level stair trench which can be modulated through ion implantation forming the first ion-implanted region 21. In case of a large surge current, depletion regions at two sides of the first ion-implanted region 21 would be automatically expanded to increase conduction resistance in the JFET region, which is equivalent to a buffer circuit structure having a self-suppression capability on surge spikes. Moreover, in case of an excessively large surge current, the depletion regions at the two sides would be further expanded to overlap with each other, which introduces an occluding effect that protects the insulating dielectric layer 17 of the trench gate and provides some protection against spike voltage. Although conduction resistance may be slightly increased due to the introduction of the JFET structure, switch buffering and self-suppression against surging voltage are achieved. That is, self-suppression capability of the device against the surge voltage and overshooting voltage is improved, and device damages and reliability reduction due to a delay in actual operation of overvoltage/overcurrent protection circuits are prevented. Moreover, spikes generated during circuit switching is buffered, which reduces a switching loss, and fewer buffer circuits or buffer structures may be deployed when designing circuits. Hence, a quantity of discrete components is reduced, which lowers costs, reduces a volume of actual modules, and improves reliability.

On a basis of the foregoing embodiments, a method for manufacturing the foregoing SiC MOSFET device is further provided according to another embodiment of the present disclosure. A process of the method may be as shown in FIG. 6 to FIG. 27.

Reference is made to FIG. 6 to FIG. 27, which are schematic structural diagrams in a process of manufacturing a SiC MOSFET device according to an embodiment of the present disclosure. The method comprises steps S11 to S14.

In the step S11, an epitaxial wafer is provided. Reference is made to FIG. 6.

The epitaxial wafer comprises a SiC epitaxial layer 11, the SiC epitaxial layer 11 comprises a first surface and a second surface that are opposite to each other, and a buried layer 12 is disposed between the first surface and the second surface. The first surface comprises a gate region and a source region, and the source region is located at two sides of the gate region.

In an embodiment, the SiC epitaxial wafer is an n-doped epitaxial layer. The epitaxial wafer may further comprise a SiC substrate 10 disposed on the second surface. The SiC epitaxial layer 11 may comprise a first epitaxial layer 111 and a second epitaxial layer 112 that are arranged opposite to each other, and the buried layer 12 is located between the first epitaxial layer 111 and the second epitaxial layer 112. A surface of the first epitaxial layer 111 away from the second epitaxial layer 112 serves as the second surface, and a surface of the second epitaxial layer 112 away from the first epitaxial layer 111 serve as the first surface.

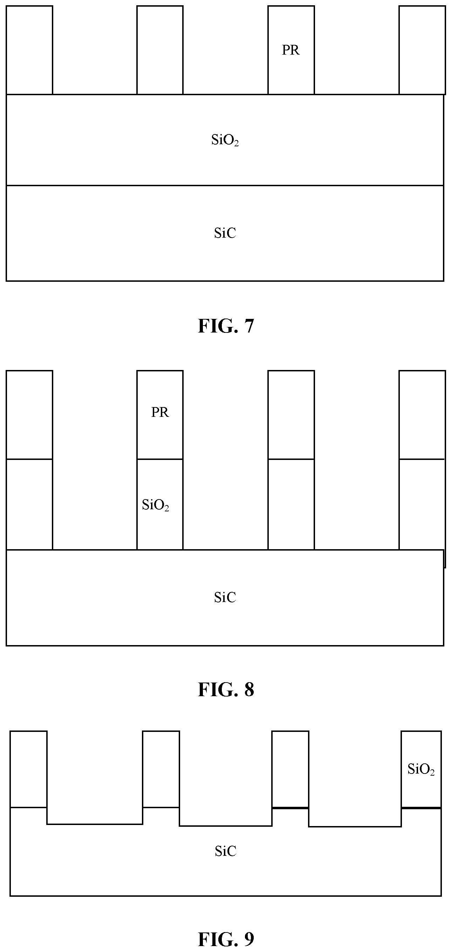

In step S12, a first trench 13 is formed in the gate region, and a second trench 14 is form in the source region. Reference is made to shown FIG. 7 to FIG. 12. The first trench 13 is located at a side of the buried layer 12 away from the second surface. The first trench is spaced apart from the buried layer 12.

Plasma dry etching, such as reactive ion etching (RIE) or inductively coupled plasma (ICP) RIE etching, may be utilized to form the first trench 13 and the second trench 14. A principle of etching on the SiC material is as shown in FIG. 7 to FIG. 9. Reference is made to FIG. 7. First, SiO₂ is formed on the SiC material as a mask layer through deposition, such as chemical vapor deposition, a photoresist (PR) is spin-coated on a surface of the mask layer, and the PR is subject to exposure and development to form a designated pattern. Reference is then made to FIG. 8. The mask layer is etched to form a patterned mask layer under masking of the patterned photoresist PR. Reference is then made to FIG. 9. The SiC material is etched under masking of the patterned mask layer to form trench(es) on its surface. Hereinafter common semiconductor processing such as photolithography and etching would be illustrated in detail.

Step S12 of forming the first trench in the gate region and forming the second trench in the source region may comprise following steps S121 and S122.

In step S121, a trench 41 of a first level is formed in the source region through first etching.

The first surface may be etched under masking of a mask layer 36, which is disposed on the first surface, to form a first-tier trench 41. After the epitaxial wafer enters a production line for processing, an alignment mark may be fabricated for positional alignment in subsequent photolithography. Herein the trench 41 of the first level may be formed along with the alignment mark, such that no additional etching is required. Reusing an etching process for forming both the alignment mark and the trench 41 is capable to reduce costs of manufacturing.

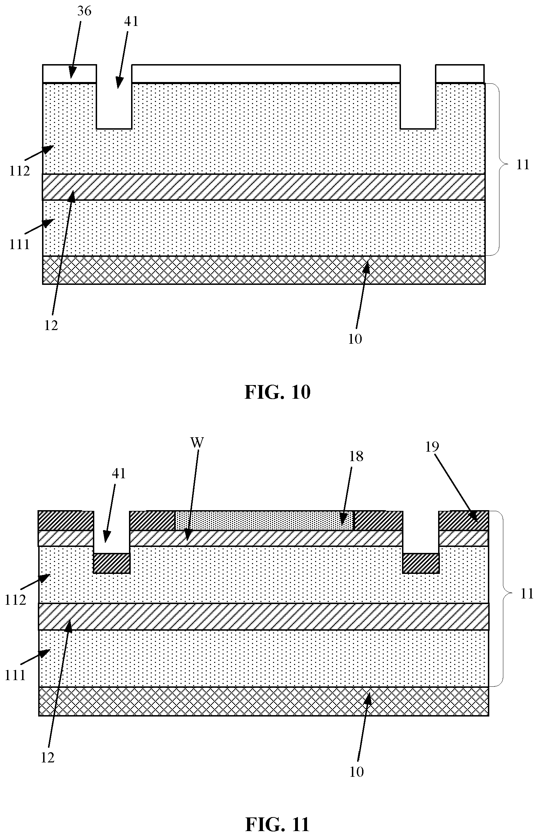

The mask layer 36 may be formed through depositing silicon oxide through CVD. A region, in which the alignment mark is to be provided, and the source region of the epitaxial wafer are etched in an RIE or ICP-RIE device under a mixed gas of a fluorine-based gas (such as CF₄ or SF₆) or a chlorine-based gas (such as Cl₂), argon, and oxygen, to form the alignment mark (not depicted in FIG. 10) and the trench 41 of the first level. A depth of the trench 41 may ranges from 200nm to 2µm, which may be determined according to a type of photolithography equipment and a type of the alignment mark. In an optional embodiment, the depth of the trench 41 is 800nm.

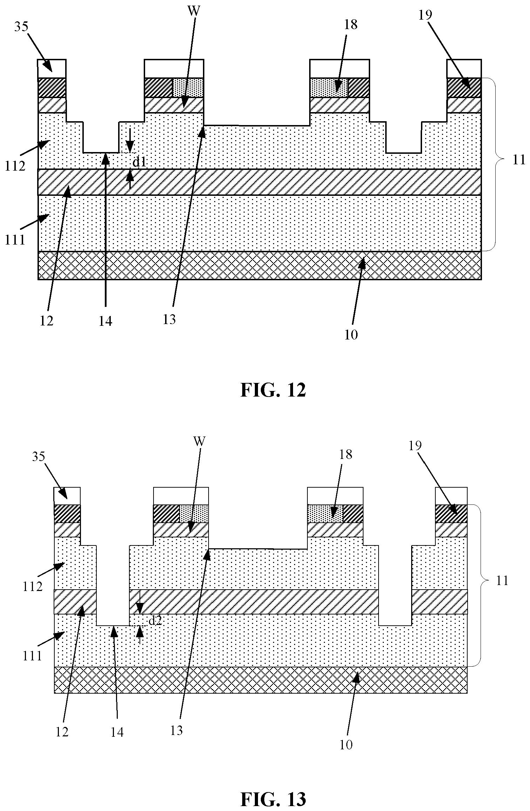

In step S122, a single-level trench is formed in the gate region, and a trench of a second level is formed on a basis of the trench of the first level, through second etching. Reference is made to FIG. 11 and FIG. 12.

An etching window of the second etching is larger than that of the first etching. The trench of the second level is formed on the basis of the trench of the first level, and simultaneously the trench of the first level is deepened. The first trench 13 comprises the single-level trench, and the second trench 14 is a two-level stair trench comprises the trench of the first level and the trench of the second level.

Before the second etching, the method further may further comprise a following step. A well region Wand a second ion-implanted region 18 that are embedded in the first surface are formed, and the well region Wand the second ion-implanted region 18 are opposite to each other in polarity of the dopants. The second ion-implanted region 18 is located at a side of the well region W facing the first surface. An electric-field buffering region 19, which surrounds the second trench 14 and is embedded in the first surface, may further be formed through ion implantation. The well region W is located between the first trench 13 and the second voltage-resistant shielding structure 16. A depth of the well region W is less than a depth of the first trench 13.

Reference is made to FIG. 11. In step S122, the mask layer 36 is removed, and then ions are implanted into the first surface to form the electric-field buffering region 19, the second ion-implanted region 18, and the well region W as required. Generally, ion implantation equipment for the SiC material utilizes high temperature ranging from 500°C to 600°C, which reduces a damage of ion implantation to the SiC lattice. Reference is then made to FIG. 12. The second etching is performed under masking of a mask layer 35.

As regards the second etching, the mask layer 35 may be silicon oxide deposited through CVD, and the SiC material covered by the gate region and the source region, which is located at two sides of the gate region, is etched in an RIE or ICP-RIE device under masking of the mask layer 35 and under a mixed gas of a fluorine-based gas (such as CF₄ or SF₆) or a chlorine-based gas (such as Cl₂), argon, and oxygen, to form the first trench 13 and the second trench 14 as shown in FIG. 12. The trench 41 of the first level formed in the gate region serves as the first trench 13, and a depth of the first trench 13 may range from 300nm to 2µm. In an optional embodiment, the depth of the first trench 13 ranges from 800nm to 1 µm.

The mask layer 35 comprises a first opening for forming the first trench 13 in a region corresponding to the first trench 13, so that the gate region can be etched via the first opening to form the first trench 13. The mask layer 35 comprise a second opening for forming the second trench in a region corresponding to the second trench, so that the source region can be etched via the second opening to form the trench of the second level on the basis of the trench of the first level. Thereby, the second trench 14 is formed.

During the second etching, the second opening for the source region is larger than an opening for forming the trench 41 of the first level, such that the two-level stair trench can be formed as the second trench 14. In such process, a bottom of the trench 41 would be deepened during the etching, and a final depth is approximately equal to a sum of an etching depth of the first etching and an etching depth of the second etching. A mouth of the trench 41 at the first surface is enlarged due to the second opening, and hence the two-level stair trench is formed.

Reference is further made to FIG. 12. In an embodiment, the sum of the etching depths in the source region is configured to be smaller than a distance between the buried layer 12 and the first surface for manufacturing the SiC MOSFET device as shown in FIG. 4. A distance d1 between the bottom of the second trench 14 and the buried layer 12 may be less than 600nm. In such case, when forming the second voltage-resistant shielding structure 16 through ion implantation in a subsequent step, energy and a dose of the implantation should be such adequate that ions can reach the buried layer 12. Thereby, the second voltage-resistant shielding structure 16 and the buried layer 12 are connected. The above case is for forming the SiC MOSFET device as shown in FIG. 4. When the device operates under a reverse voltage, a region subject to highest electric field is uniformly distributed in the buried layer 12, and the device has good endurance against the reverse voltage.

Reference is made to FIG. 13. In another embodiment, the sum of the etching depths in the source region is configured to be larger than a distance between the buried layer 12 and the first surface for manufacturing the SiC MOSFET device as shown in FIG. 5. The mask layer 35 may be silicon oxide deposited through CVD, and the SiC material covered by the gate region and the source region, which is located at two sides of the gate region, is etched in an RIE or ICP-RIE device under masking of the mask layer 35 and under a mixed gas of a fluorine-based gas (such as CF₄ or SF₆) or a chlorine-based gas (such as Cl₂), argon, and oxygen, to form the structure as shown in FIG. 12. The single-level trench is formed in the gate region and serves as the first trench 13, and a depth of the first trench 13 ranges from 300nm to 2µm. In an optional embodiment, the depth of the first trench 13 ranges from 800nm to 1 µm. In such case, the second trench 14 runs through the buried layer 12. A distance d2 between the bottom of the second trench 14 and the buried layer 12 is less than 600nm. When the second voltage-resistant shielding structure 16 is formed through ion implantation in a subsequent step, since the second trench 16 runs through the buried layer 12, only a low dose and low energy are required in the implantation for connecting the second voltage-resistant shielding structure 16 and the buried layer 12, in comparison with the case as shown in FIG. 12. The above case is for forming the SiC MOSFET device as shown in FIG. 5. When the device operates under a reverse voltage, the second voltage-resistant shielding structure 16 at a bottom of the second trench 14 is subject to highest electric field, and an area of a region subject to the highest electric field depends on a width of the bottom of the second trench 14. Endurance against the reverse voltage is lower than that in the case as shown in FIG. 4.

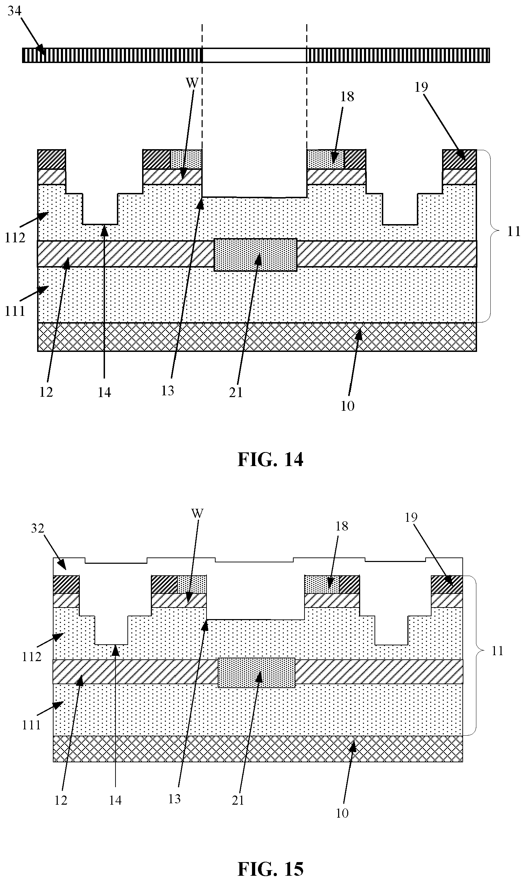

In step 13, the first voltage-resistant shielding structure 15 is formed in the SiC epitaxial layer 11 through the first trench, and the second voltage-resistant shielding structure 16 is formed in the SiC epitaxial layer 11 through the second trench. Reference is made to FIG. 14 to FIG. 19. The first voltage-resistant shielding structure 15 is spaced apart from the buried layer 12, and the second voltage-resistant shielding structure 16 is in contact with the buried layer 12.

Before forming the first voltage-resistant shielding structure 15 and the second voltage-resistant shielding structure 16, the method may further comprise a following step. Reference is made to FIG. 14. Ions are implanted into the buried layer 12 via the first trench 13 to form a first ion-implanted region 21 in a region of the buried layer 12 corresponding to the first trench 13. The first ion-implanted region 21 runs through the buried layer 12. After the first voltage-resistant shielding structure 15 is formed in a subsequent step, it would be spaced apart from the first ion-implanted region 21. A mask plate 34 may be utilized to expose the first trench 13 and shield other regions on the first surface. The first ion-implanted region 21 may be formed using a source of nitrogen ions.

The ions may be implanted using a photoresist mask or an auxiliary hard mask made of silicon oxide. In case of the photoresist mask, a photoresist may be directly spin-coated on the first surface. A bottom of the first trench 13 may be exposed through development in photolithography under masking of a mask plate 34 as shown in FIG. 14. An opening in a patter of the mask plate 34, which corresponds to the first trench 34, is smaller than the first trench 13.

The electric-field buffering region 19 in the first surface may surround the second trench. Forming the first voltage-resistant shielding structure 15 in the SiC epitaxial layer 11 through the first trench 13 and forming the second voltage-resistant shielding structure 16 in the SiC epitaxial layer 11 through the second trench 14 may comprise following steps S131 and S132.

Reference is made to FIG. 15 to FIG. 17. In step S131, a mask layer 32 is formed. The mask layer 32 covers the first surface and a sidewall of the first trench.

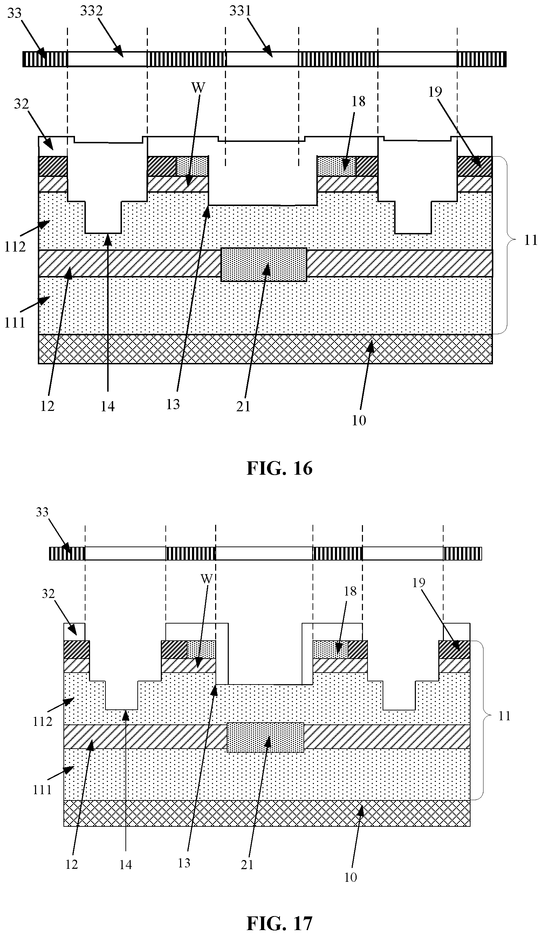

Reference is first made to FIG. 15. In step S131, the mask layer 32 that covers the first surface and fills the first trench 13 and the second trench 14 may be first formed. The mask layer 32 may be silicon oxide deposited through CVD. Reference is then made to FIG. 16. A photolithography mask layer 33 is provided. An opening 331 of the photolithography mask layer 33, which corresponds to the first trench 13, is smaller than a mouth of the first trench 13. An opening 332 of the photolithography mask layer 33, which corresponds to the second trench 14 is larger than a mouth of the second trench 14. Reference is then made to FIG. 17. Photolithography is performed according to the photolithography mask layer 33. The mask layer 32 may be etched through dry etching using a gas having high selectivity with respect to SiO₂: SiC.

Since the opening 331 is smaller than the mouth of the first trench 13, a portion of the mask layer 32 on the sidewall of the first trench 13 is reserved. When ions are implanted in a subsequent step for forming the first voltage-resistant shielding structure 15, such portion of the mask layer 32 is capable to prevent the scattered ions from being injected into the sidewall of the first trench 13. Consequently, the first voltage-resistant shielding structure 15 is formed at a position lower than well region W and is prevented from contacting the well region W Thereby, abnormal conduction of the channel due to such contact is avoided, and normal operation of the device is ensured.

Since the opening 332 is larger than the mouth of the second trench 14, a portion of the first surface surrounding the second trench 14 is exposed. When ions are implanted in a subsequent step for forming the second voltage-resistant shielding structure 16, the entire second trench 14 are subject to ion implantation. Hence, the ions are implanted into the SiC epitaxial layer 11 at a bottom of the second trench 14, a sidewall of each level in the second trench 14, and the step surface between two adjacent levels of the second trench to form the required second voltage-resistant shielding structure 16. When the resulted device operates under a reverse voltage, the second voltage-resistant shielding structure 16 can shield and protect the trench source completely to avoid a large reverse leakage.

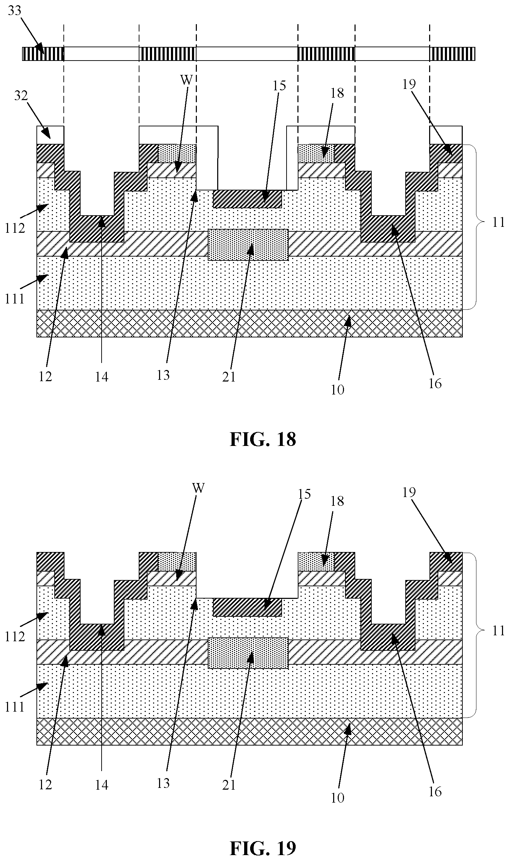

In step S132, the first voltage-resistant shielding structure 15 are formed in the SiC mask layer 11 at a bottom of the first trench 13, and the second voltage-resistant shielding structure 16 is formed at a sidewall and a bottom of the second trench 14, through ion implantation using the mask layer 32. Refence is then made to FIG. 19. The mask layer 32 is removed. The mask layer 32 may be removed through a wet manner using buffered HF.

The electric-field buffering region 19 surrounds the second voltage-resistant shielding structure 16. The electric-field buffering region 19 and the second voltage-resistant shielding structure 16 may be identical in doping and integrated as a whole. Ion implantation equipment may be utilized for implanting p+ ions under high temperature ranging from 500°C to 600°C to form the first voltage-resistant shielding structure 15 and the second voltage-resistant shielding structure 16. The implanted p+ ions may be Aluminum ions. In an optional embodiment, energy of the ions may be several hundreds of kilo-electron-volts, a dose of the ions ranges from 1×10¹²cm⁻² to 1×10¹⁶cm⁻² , and a depth of the implantation ranges from 100nm to 500nm.

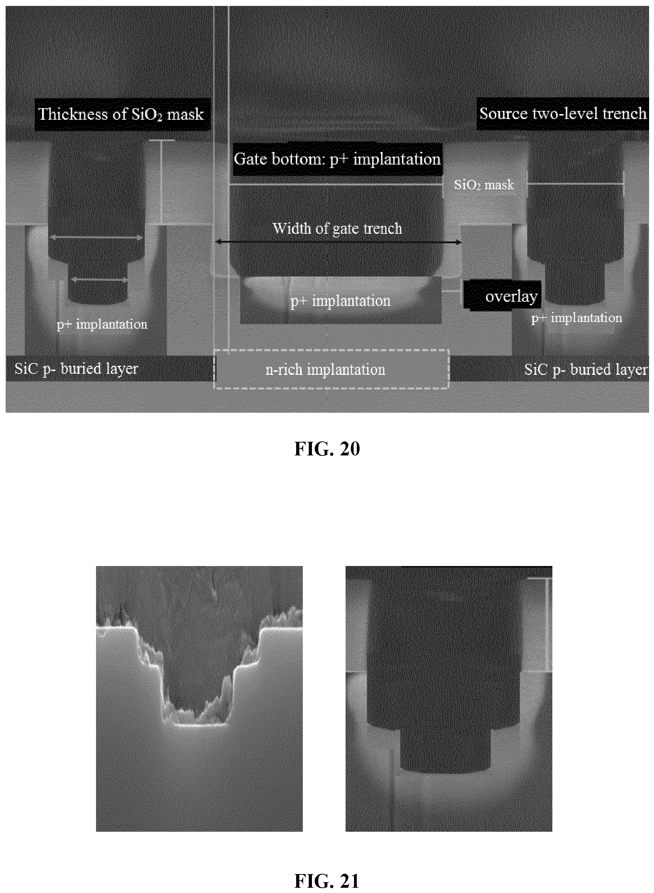

Reference is made to FIG. 20, which is a scanning electron microscopy (SEM) image obtained after the first voltage-resistant shielding structure 15 and the second voltage-resistant shielding structure 16 have been formed in a process of a method according to an embodiment of the present disclosure. The buried layer 12 is a p-doped SiC buried layer. A region corresponding to the first trench comprises an n-rich (n-doped) ion-implanted region which serves as the first ion-implanted region 21. Silicon oxide is provided on the first surface of the epitaxial wafer as the mask layer 32. The second voltage-resistant shielding structure 16 and the buried layer 12 overlay with each other to achieve connection between the two.

Reference is made to FIG. 21, which shows SEM images of the source region before and after implanting the p+ ions in the method according to an embodiment of the present disclosure. It is taken as an example that the second trench 14 is the two-level stair trench. The left figure shows the SEM image of a region corresponding to the second trench 14 before implanting the p+ ions, while the right figure shows the SEM image of the region after implanting the p+ ions. In the right figure, a region with a lower grayscale indicates implantation of Aluminum ions in the SEM slice image.

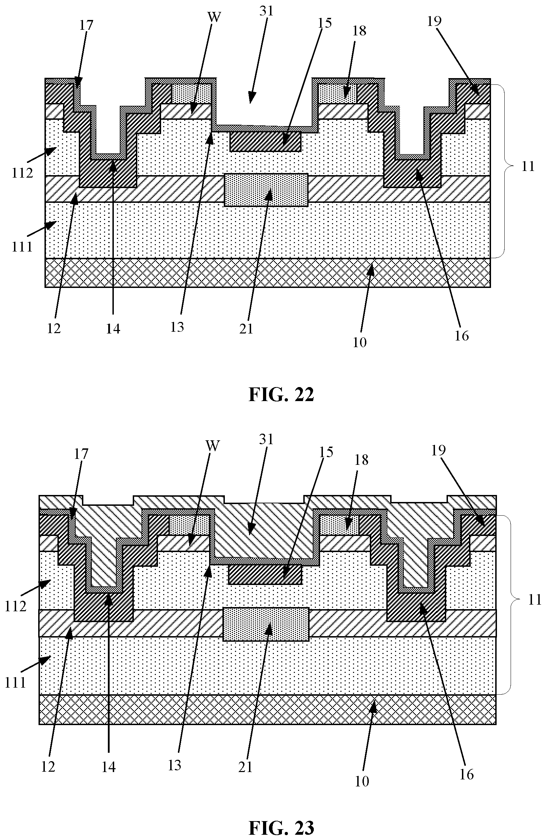

In step S14, a trench gate g is formed in the first trench 13, and a trench source s is formed in the second trench 14. Reference is made to FIG. 22 to FIG. 26.

Step S14 of forming the trench gate g in the first trench 13 and forming the trench source s in the second trench 14 may include steps S141 to S145.

In step S141, an insulating dielectric layer 17 is formed. Reference is made to FIG. 22. The insulating dielectric layer 17 covers the first surface, the surface of the first trench 13, and the surface of the second trench 14.

A trench gate oxide layer grown in a high temperature furnace tube may serve as the insulating dielectric layer 17. Silicon oxide may be grown through introducing oxygen into the high temperature furnace tube under temperature ranging from 1100°C to 1350°C. A thickness of the silicon oxide ranges from 40nm to 70nm.

In step S142, the first trench 13 and the second trench 14 are filled with polysilicon 31. Reference is made to FIG. 23. The trench gate g comprises the polysilicon 31 filling the first trench 13, and a gate metal G would be disposed on a surface of such polysilicon 31. The trench source s comprises the polysilicon 31 filling the second trench 14, and a source metal S would be disposed on a surface of such polysilicon 31.

A polysilicon layer may be deposited through low pressure CVD (LPCVD) to fill the first trench 13 and the second trench 14. In an embodiment, silane or dichlorosilane (DCS), Ar, and a dopant gas comprises phosphorus or boron (such as phosphine or borane) are introduced into an LPCVD furnace tube under temperature ranging from 540°C to 800°C to fabricate polysilicon through chemical pyrolysis reaction. A thickness of the polysilicon may range from 400nm to several microns. Subsequent steps are configured to facilitate forming the metal electrodes.

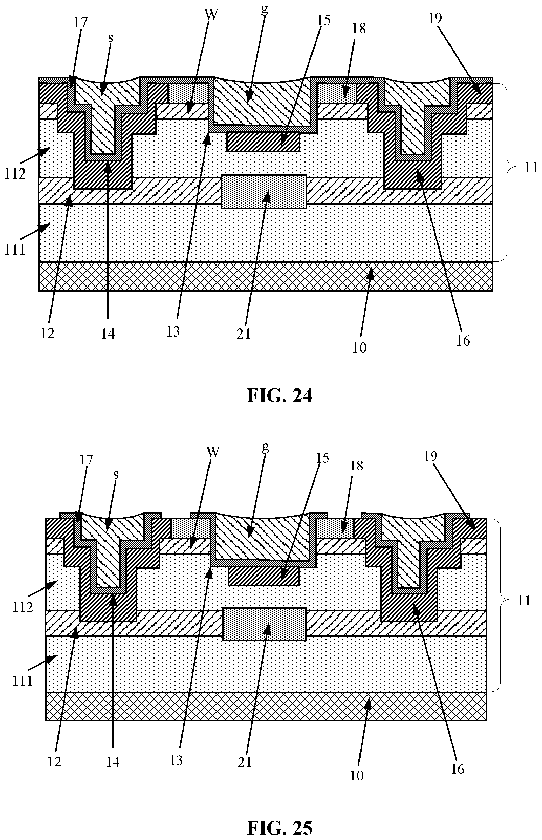

In step S143, the polysilicon 31 which is outside of the first trench 13 and the second trench 14 and on the first surface, is removed through etching. Reference is made to FIG. 24. An upper surface of the polysilicon filling the first trench 13 is slightly lower than an edge of the mouth of the first trench 13, and an upper surface of the polysilicon filling the second trench 14 is slightly lower than an edge of the mouth of the second trench 14, which facilitates subsequent formation of the source metal S and the gate metal G. The polysilicon may be etched using a mixed gas of HBr, chlorine, and oxygen.

In step S144, an opening is formed in the insulating dielectric layer 17 outside of the first trench 13 and the second trench 14. Reference is made to FIG. 25. The insulating dielectric layer 17 may be etched using a fluorine-based gas (such as CHF₃ or CF₄) or a chlorine-based gas to form the opening. The opening is configured for forming an ohmic contact layer 20 in a subsequent step.

In step S145, the ohmic contact layer 20 is formed in the opening of the insulating dielectric layer 17. In an embodiment, a single layer of Ni or a stacked layer of Ti/Ni/Al is deposited in the opening through physical vapor deposition (PVD), and then the metal outside of the opening is removed through stripping or etching. Afterwards, rapid thermal annealing is performed under temperature ranging from 900°C to 1100°C for a period ranging from 30 seconds to 5 minutes to form the ohmic contact layer 20.

As a last step, the gate metal G is formed on the surface of the trench gate g, the source metal S is formed on the surface of the trench source s, and a drain metal D is formed on a surface of the SiC substrate 10 away from the SiC epitaxial layer 11. Thereby, the SiC MOSFET device as shown in FIG. 4 is formed. The source metal S is located on the surface of the polysilicon filling the second trench 14, covers the ohmic contact layer 20, and is connected to the ohmic contact layer 20. The drain metal D may have a stacked structure comprising one or more of Ni, Ti, Al, and Ag.

Subsequent metal processing related to the gate and the source, processing related to a passivation layer and polyimide (PI) adhesive, and metal processing related to the backside drain may all refer to conventional processing and would not be illustrated herein.

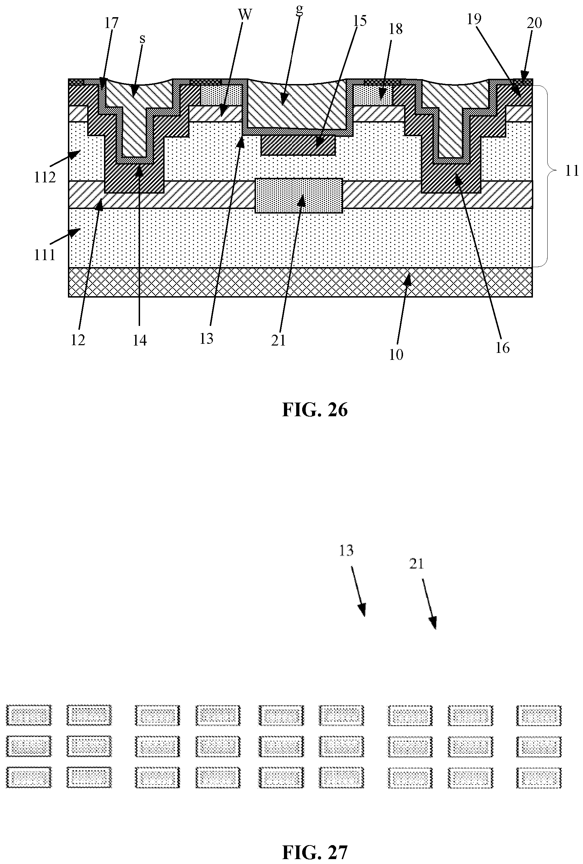

Reference is made to FIG. 27, which is a layout showing a design of trenches and areas of ion implantation for doped regions of a SiC MOSFET device according to an embodiment of the present disclosure. Each window for ion implantation of the first ion-implanted region 21 is located within the corresponding first trench 13. A channel characteristics of the JFET structure may be adjusted through pattern design, concentration of implanted ions, and a shape, of the first ion-implanted region 21. An area of the ion-implantation window of the first ion-implanted region 21 may be less than or equal to an area of the first trench 13.

Manufacture of the SiC MOSFET device as shown in FIG. 4 is taken as an example in illustration of the above process. On a basis of such process, the bottom of the second trench 14 may be configured as located in the buried layer 12 or beneath the buried layer 12 through setting the depths of the first etching and the second etching for forming the second trench 14, such that another process may be obtained. In such case, the SiC MOSFET device shown in FIG. 5 may be manufactured, and the second voltage-resistant shielding structure 16 can be connected to the buried layer 12 through implanting ions under low energy to achieve the modulation on the parasitic JFET structure on the current path. Hence, requirements on parameters and manufacturing of the device.

Thereby, an ingenious solution for integration processing is provided according to embodiments of the present disclosure. The second voltage-resistant shielding structure 16 is formed through the second trench 14 to achieve its connection with the buried layer 12, and thereby it is grounded. Such solution in conjunction with the structure of the epitaxial wafer and the first ion-implanted region 21 addresses the difficulties of shielding the gate insulating dielectric layer 17 and implementing deep p-type ion implantation in SiC materials of the SiC trench MOSFET device. Additionally, the JFET structure may be introduced into the current path to the drain, that is, the JFET structure is grounded via the two-level trench and can be modulated through implantation in the ion-implanted region 21. Conduction resistance of the device and a self-locking protection effect can be automatically adjusted while maintaining a small cell size of the device.

According to the method provided, the p+ ions can be implanted using low energy, e.g., lower than 1MeV, and a depth of the implantation can be smaller than 1µm. In such case, the buried layer 12 which has a depth of more than 1µm with respect to the first surface with can still be connected to the source and thus grounded. The technical solution of the present disclosure provides an ingenious solution for integration processing, in which the buried structure is grounded via the two-level stair trench, and the first ion-implanted region 21 is formed in the buried layer 12 of the epitaxial wafer. Thereby, the difficulties of shielding the gate insulating dielectric layer 17 and implementing deep p-type ion implantation in SiC materials of the SiC trench MOSFET device are addressed, and the JFET structure grounded via the two-level trench and tunable through implantation in the ion-implanted region 21 can be introduced into the current path to the drain. Conduction resistance of the device and a self-locking protection effect can be automatically adjusted while maintaining a small cell size of the device.

The embodiments of the present disclosure are described in a progressive manner, a parallel manner, or a combination of the two. Each embodiment places emphasis on the difference from other embodiments. Therefore, one embodiment can refer to other embodiments for the same or similar parts.

Herein the description of the drawings and embodiments is illustrative rather than restrictive. The same reference numeral throughout embodiments of the present disclosure presents the same structure. In addition, for the sake of understanding and ease of description, the drawings may exaggerate the thickness of some layers, films, panels, regions, or the like. When an element such as a layer, film, region, or substrate is described to be "on" another element, the element may be directly on the other element or there may be an intermediate element between the two. In addition, "on" means positioning an element above or below another element, and such positioning does not necessarily refer to positioning on an upper side of the other element with respect to a direction of gravity.

Herein terms indicating orientation or a positional relationship, such as "up", "low", "top", "bottom", "inner", "outer", and the like, are based on the orientation or the positional relationship as shown in the drawings. These terms are only intended for facilitating and simplifying description of the present disclosure, and do not explicitly or implicitly indicate that concerning devices or elements must have a specific orientation or must be constructed and operated based on a specific orientation. Therefore, the orientation or the positional relationship shall not be construed as a limitation on the present disclosure. In a case that a component is described to be "connected" to another component, it may be connected directly to the other component, or there may be an intermediate component between the two.

It should be noted that, the relationship terms such as "first", "second" and the like are only used herein to distinguish one entity or operation from another, rather than to necessitate or imply that an actual relationship or order exists between the entities or operations. Furthermore, the terms such as "include", "comprise" or any other variants thereof means to be non-exclusive. Therefore, a process, a method, an article, or a device including a series of elements include not only the disclosed elements but also other elements that are not clearly enumerated, or further include inherent elements of the process, the method, the article, or the device. Unless expressively limited, the statement "including a..." does not exclude the case that other similar elements may exist in the process, the method, the article, or the device other than enumerated elements.

According to the description of the disclosed embodiments, those skilled in the art can implement or use the present disclosure. Various modifications made to these embodiments may be obvious to those skilled in the art, and the general principle defined herein may be implemented in other embodiments without departing from the spirit or scope of the present disclosure. Therefore, the present disclosure is not limited to the embodiments described herein but conforms to the widest scope in accordance with principles and novel features disclosed in the present disclosure.

## Claims

1. A silicon carbide metal-oxide-semiconductor field-effect-transistor (MOSFET), comprising:
a silicon carbide epitaxial layer, comprising a first surface and a second surface that are opposite to each other, wherein a buried layer is disposed between the first surface and the second surface, the first surface comprises a gate region and a source region, and the source region is located at two sides of the gate region;
a first trench that opens in the gate region, and a trench gate disposed in the first trench, wherein the first trench is located at a side of the buried layer away from the second surface, and the first trench is spaced apart from the buried layer;
a second trench that opens in the source region, and a trench source disposed in the second trench;
a first voltage-resistant shielding structure embedded in the silicon carbide epitaxial layer at a bottom of the first trench, wherein the first voltage-resistant shielding structure is spaced apart from the buried layer; and
a second voltage-resistant shielding structure embedded in the silicon carbide epitaxial layer at a surface of the second trench, wherein the second voltage-resistant shielding structure is in contact with the buried layer.

2. The silicon carbide MOSFET device according to claim 1, wherein:
the buried layer comprises a first ion-implanted region formed through the first trench, and
the first ion-implanted region runs through the buried layer and is spaced apart from the first voltage-resistant shielding structure.

3. The silicon carbide MOSFET device according to claim 2, wherein:
the first trench is a single-level trench, a width of the first ion-implanted region is less than a width of the single-level trench, and a width of the first voltage-resistant shielding structure is less than the width of the single-level trench.

4. The silicon carbide MOSFET device according to claim 1, wherein:
a depth of the first trench is less than a depth of the second trench;
a well region is located between the first trench and the second voltage-resistant shielding structure, and a depth of the well region is less than the depth of the first trench; and
a part of the silicon carbide epitaxial layer located at a side of the well region away from the second surface serves as a second ion-implanted region, and a polarity of dopants in the well region is opposite to a polarity of dopants in the second ion-implanted region.

5. The silicon carbide MOSFET device according to claim 1, wherein:
the second trench is a multi-level stair trench;
the second voltage-resistant shielding structure is a third ion-implanted region formed through the multi-level stair trench;
the third ion-implanted region is embedded in the silicon carbide epitaxial layer at a bottom of the multi-level stair trench, a sidewall of each level of the multi-level stair trench, and a step surface between every two adjacent levels of the multi-level stair trench.

6. The silicon carbide MOSFET device according to claim 1, wherein:
a bottom of the second trench is located at a side of the buried layer away from the second surface and is spaced apart from the buried layer; and
at least a portion of the second voltage-resistant shielding structure runs into the buried layer.

7. The silicon carbide MOSFET device according to claim 1, wherein at least a portion of the second trench runs into the buried layer.

8. The silicon carbide MOSFET device according to claim 1, wherein:
the trench gate comprises polysilicon filling the first trench, and a gate metal is disposed on a surface of the polysilicon filling the first trench;
the trench source comprises polysilicon filling the second trench, and a source metal is disposed on a surface of the polysilicon filling the second trench;
an insulating dielectric layer comprises a part disposed between the first trench and the polysilicon filling the first trench, a part disposed between the second trench and the polysilicon filling the second trench, and a part covering the first surface; and
the part covering the first surface comprises an opening that exposes a portion of the first surface, the opening is configured to accommodate an ohmic contact layer, and the source metal covers the ohmic contact layer.

9. The silicon carbide MOSFET device according to claim 1, further comprising:
a silicon carbide substrate disposed on the second surface, wherein a drain metal is disposed at a side of the silicon carbide substrate away from the silicon carbide epitaxial layer.

10. A method for manufacturing the silicon carbide metal-oxide-semiconductor field-effect-transistor (MOSFET) device according to any one of claims 1 to 9, comprising:
providing an epitaxial wafer comprising a silicon carbide epitaxial layer, wherein:
the SiC epitaxial layer comprises a first surface and a second surface that are opposite to each other,
a buried layer is disposed between the first surface and the second surface,
the first surface comprises a gate region and a source region, and
the source region is located at two sides of the gate region;
forming a first trench opening in the gate region and forming a second trench opening in the source region, wherein the first trench is located at a side of the buried layer away from the second surface, and the first trench is spaced apart from the buried layer;
forming a first voltage-resistant shielding structure in the silicon carbide epitaxial layer through the first trench and forming a second voltage-resistant shielding structure in the SiC epitaxial layer through the second trench, wherein the first voltage-resistant shielding structure is spaced apart from the buried layer, and the second voltage-resistant shielding structure is in contact with the buried layer; and
forming a trench gate in the first trench and forming a trench source in the second trench.

11. The method according to claim 10, wherein before forming the first voltage-resistant shielding structure and forming the second voltage-resistant shielding structure, the method further comprises:
implanting ions into the buried layer through the first trench to form a first ion-implanted region in a region of the buried layer corresponding to the first trench,
wherein the first ion-implanted region runs through the buried layer and is spaced apart from the first voltage-resistant shielding structure.

12. The method according to claim 10, wherein forming the first trench in the gate region and forming the second trench in the source region comprises:
forming a trench of a first level in the source region through first etching;
forming a single-level trench in the gate region and forming a trench of a second level overlapping with the trench of the first level, through second etching, wherein:
an etching window of the second etching is larger than an etching window of the first etching,
the trench of the first level is deepened while forming the trench of the second level,
the first trench comprises a single-level trench, and the second trench is a two-level stair trench comprising the deepened trench of the first level and the trench of the second level.

13. The method according to claim 10, wherein further comprising:
forming a well region and a second ion-implanted region that are embedded in the first surface, wherein:
a polarity of dopants in the second ion-implanted region is opposite to the polarity of dopants in the well region, the well region is located between the first trench and the second voltage-resistant shielding structure, and a depth of the well region is less than a depth of the first trench.

14. The method according to claim 10, wherein:
an electric-field buffering region in the first surface surrounds the second trench; and
forming the first voltage-resistant shielding structure in the silicon carbide epitaxial layer through the first trench and forming the second voltage-resistant shielding structure in the silicon carbide epitaxial layer through the second trench comprises:
forming a mask layer covering the first surface and a sidewall of the first trench; and
through ion implantation under masking of the mask layer,
forming the first voltage-resistant shielding structure in the silicon carbide epitaxial layer at a bottom of the first trench, and
forming the second voltage-resistant shielding structure at a sidewall and a bottom of the second trench;
wherein the electric-field buffering region surrounds the second voltage-resistant shielding structure.

15. The method according to claim 10, wherein forming the trench gate in the first trench and forming the trench source in the second trench comprises:
forming an insulating dielectric layer that covers the first surface, a surface of the first trench, and a surface of the second trench;
filling the first trench and the second trench with polysilicon, wherein:
the trench gate comprises the polysilicon filling the first trench, and a gate metal is disposed on a surface of the polysilicon filling the first trench; and
the trench source comprises the polysilicon filling the second trench, and a source metal is disposed on a surface of the polysilicon filling the second trench.
